# EUROPÄISCHE PATENTSCHRIFT

(11) **EP 0 635 760 B1**
(45) Veröffentlichungstag und Bekanntmachung des Hinweises auf die Patenterteilung: **15.05.1996**
(21) Anmeldenummer: 94110695.7
(22) Anmeldetag: 09.07.1994
(51) Int. Cl.: G03F 7/11

(54) **Verfahren zur Herstellung von Mikrostrukturkörpern**
Process for making microstructures
Procédé pour fabriquer des microstructures

(30) Priorität: 19.07.1993 DE 4324079
(43) Veröffentlichungstag der Anmeldung: 25.01.1995
(73) Patentinhaber: BASF Aktiengesellschaft, D-67063 Ludwigshafen (DE)
(72) Erfinder: Haeussling, Lukas, Dr., D-55452 Laubenheim (DE); Hoffmann, Gerhard, Dr., D-67166 Otterstadt (DE); Harth, Klaus, Dr., D-67317 Altleiningen (DE); Hibst, Hartmut, Dr., D-69198 Schriesheim (DE)

(56) Entgegenhaltungen:
- EP-A- 0 547 419
- EP-A- 0 580 036
- US-A- 3 645 772

## Beschreibung

Die Erfindung betrifft ein Verfahren zur Herstellung von Mikrostrukturkörpern mit Strukturtiefen von mehreren µm bis in den mm-Bereich durch bildmäßiges Bestrahlen von Polymeren, die auf dimensionsstabilen Trägern mittels einer oder mehrerer Haftschichten aufgebracht sind, mit Synchrotronstrahlung und Entfernen der bildmäßig bestrahlten Bereiche, wobei bestimmte Haftschichten verwendet werden.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gestaltungsmöglichkeiten erschließen zu können, die auf einer Vielfalt von Formen und Materialien aufbauen. Diese Forderung wird z.B. in hohem Maße durch das LIGA-Verfahren erfüllt, das auf den Fertigungsschritten
- Lithographie
- Galvanoformung und
- Abformung
aufgebaut und am Kernforschungszentrum Karlsruhe (KfK) entwickelt worden ist.

Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membrane und vieles andere mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Für die Herstellung komplexer dreidimensionaler Strukturen mit Strukturtiefen mit mehreren µm bis in den mm-Bereich nach dem oben genannten LIGA-Verfahren, muß das PMMA oder andere, z.B. in den Patentanmeldungen DE-A-41 07 662, DE-A-41 07 851 und DE-A-41 41 352 beschriebene röntgenlichtempfindliche spezielle Polymere auf eine leitfähige Trägerplatte aufgebracht werden.

Bisher wird im Prozeß als Haftschicht Titan verwendet, welches durch Bedampfen oder Besputtern auf einen Kupferträger aufgebracht und anschließend oberflächlich oxidiert wird (vgl. W. Ehrfeld, P. Bley, F. Götz, J. Mohr, D. Münchmeyer, W. Schelb, H.J. Baring, D. Beets, J. Vac. Sci. Technol. B6 (1) Jan/Feb 1988, S. 178).

Diese Verfahrensweise zeigte sich jedoch noch nicht optimal, da sowohl die Haftung der Polymeren auf der elektrisch leitfähigen Trägerplatte als auch die Startpunktdichte beim nachfolgenden Galvanikprozeß nur mäßig sind, die Reproduzierbarkeit der oberflächlich durch Oxidation erzeugten Haftschicht unzureichend ist und an der Grenzschicht von Polymer zu Titan bzw. Titanoxid es aufgrund der höheren Röntgenlichtabsorption von Titan zu einem sprunghaften Anstieg der abgelagerten Dosis und damit zu einer unerwünschten Wärmeentwicklung und zu Rückstreueffekten von Strahlung und Elektronen kommt.

Ein Verfahren zur Herstellung von Mikrostrukturkörpern, wobei als Haftschichten solche aus mindestens zwei unterschiedlichen Elementen, von denen eines vor dem Auftragen des Polymeren selektiv oder teilweise entfernt wird, eingesetzt werden, wurde bereits in der DE-A-4 223 886 vorgeschlagen.

Aufgabe der vorliegenden Erfindung war es, ein geeignetes Verfahren zu entwickeln, mit welchem die oben genannten Nachteile vermeidbar sind. Es sollte ein Verfahren gefunden werden, mit welchem chem geeignete und für das LIGA-Verfahren adaptierte Haftschichten auf einen dimensionsstabilen Träger in besonders einfacher Weise aufgebracht werden können.

Überraschend wurde gefunden, daß ein Verfahren, bei dem Kohlenstoff oder Kohlenwasserstoffe mit unterstöchiometrischem Gehalt an Wasserstoff durch Aufdampfen oder Kathodenzerstäubung auf einen, gegebenenfalls vorbehandelten, dimensionsstabilen Träger abgeschieden wird, Haftschichten ermöglicht, welche die oben genannten Nachteile nicht aufweisen.

Gegenstand der vorliegenden Erfindung ist ein Verfahren zur Herstellung von Mikrostrukturkörpern mit Strukturtiefen von mehreren µm bis in den mm-Bereich durch bildmäßiges Bestrahlen von Polymeren, die auf dimensionsstabilen Trägern mittels einer oder mehrerer Haftschichten aufgebracht sind, mit Synchrotronstrahlung und Entfernen der bildmäßig bestrahlten Bereiche, das dadurch gekennzeichnet ist, daß die oberste, das Polymer berührende Haftschicht aus Kohlenstoff oder Kohlenwasserstoffen mit unterstöchiometrischem Gehalt an Wasserstoff besteht, wobei diese Haftschicht durch Aufdampfen, Kathodenzerstäubung oder plasmaunterstützte chemische Gasphasenabscheidung auf den dimensionsstabilen Träger aufgebracht wird.

Die Schichtdicke der obersten Haftschicht beträgt vorzugsweise 10⁻³ µm bis 10 µm.

Nach dem erfindungsgemäßen Verfahren lassen sich aus einem röntgenlichtempfindlichen Polymeren Mikrostrukturkörper mit Strukturtiefen zwischen 3 µm und 2000 µm und lateralen Abmessungen von unter 10 µm herstellen.

Das erfindungsgemäße Verfahren eignet sich insbesondere dazu, anschließend die für das LIGA-Verfahren üblichen Galvanikprozeßschritte und Abformprozeßschritte durchzuführen und Mikrostrukturkörper aus Metallen oder Kunststoffen herzustellen.

Zum erfindungsgemäßen Verfahren ist im einzelnen folgendes auszuführen.

Als Träger können verschiedene dimensionsstabile Materialien eingesetzt werden, beispielsweise elektrisch leitfähige Materialien Halbleiter- oder isolierende Materialien, bevorzugt sind Metalle, z.B. Stahl, Nickel, Aluminium oder Kupfer; besonders bevorzugt ist Kupfer beispielsweise mit einer Schichtdicke von 8 mm. Als Halbleitereigenschaften aufweisende Träger kommen z.B. Siliciumwafer in Frage. Geeignete isolierende Träger sind z.B. Aluminiumoxidkeramiken.

Der Träger kann vor dem Auftrag der Haftschicht(en) in vorteilhafter Weise einer Oberflächenbehandlung unterzogen werden, beispielsweise durch eine Plasmaätzbehandlung in einer Edelgasatmosphäre, z.B. in Argon.

Die Schichtdicke der Haftschicht kann zwischen 10⁻³ µm und 10 µm, vorzugsweise zwischen 0,1 bis 1 µm betragen.

Für das erfindungsgemäße Verfahren geeignete Kohlenstoffmodifikationen sind z.B., wenn es sich um reinen Kohlenstoff handelt, Diamant, Graphit und amorpher Kohlenstoff.

Ebenso eignen sich insbesondere Kohlenwasserstoffe mit unterstöchiometrischem Gehalt an Wasserstoff.

Die erfindungsgemäße Herstellung der Haftschichten kann durch Aufdampfen, Lichtbogenbeschichtung oder plasmaunterstützte chemische Gasphasenabscheidung oder in bevorzugter Weise durch Kathodenzerstäubung (Sputtern) erfolgen. Diese Methoden sind beispielsweise in Handbook of Thin Film Deposition, Processes and Techniques (Klaus K. Schuegraf, Noyes Publications New Jersey, 1988, S. 112-146 bzw. 291-317) beschrieben. Für das erfindungsgemäße Verfahren sind verschiedene methodische Varianten der Kathodenzerstäubung, wie Magnetron-Sputtern, DC- bzw. RF-Sputtern, Bias-Sputtern oder reaktives Sputtern sowie deren Kombinationen geeignet. Beim Magnetron-Sputtern befindet sich das zu zerstäubende Target in einem äußeren Magnetfeld, welches das Plasma in den Bereich des Targets konzentriert und damit eine Erhöhung der Zerstäubungsrate bewirkt. Beim DC- bzw. RF-Sputtern erfolgt die Anregung des Zerstäubungsplasmas in an sich bekannter Weise durch DC- bzw. RF-Generatoren. DC- und RF-Generatoren sind Netzteile zum Erzeugen von Gleichspannungen (DC) oder Hochfrequenzspannungen (RF). Beim Bias-Sputtern wird der zu beschichtende Formkörper mit einer in der Regel negativen Vorspannung (Bias) belegt, welche während der Beschichtung zu einem intensiven Beschuß des Formkörpers mit Ionen führt.

Es kann von Vorteil sein, daß unter der Haftschicht aus Kohlenstoff oder dem Kohlenwasserstoff mit unterstöchiometrischem Gehalt an Wasserstoff auf dem Träger eine oder mehrere weitere haftvermittelnde Schichten angebracht sind, die beispielsweise aus bestimmten Metallen, vorzugsweise Titan oder Chrom bestehen und Schichtendikche zwischen 10⁻⁴ und 1 µm aufweisen können.

Als Polymere können alle für das LIGA-Verfahren geeignete Röntgenresiste eingesetzt werden; bevorzugt sind Resiste auf der Basis von Polymethylmethacrylat, Polyoxymethylene und aliphatische Polyester, z.B. Polylactide und Polylactid-co-glycolide, sowie Polycarbonate und Polycarbonat-Blends.

Die Polymeren können nach dem Gießverfahren, einem Preßverfahren, durch Spritzguß oder durch eine Kombination aus Extrusion und Kalandrieren einer Polymerfolie auf den mit der Haftschicht beschichteten Träger aufgebracht werden.

Die in den Beispielen genannten Teile und Prozente sind, soweit nicht anders angegeben, Gewichtsteile bzw. Gewichtsprozente.

### Beispiel 1

### A. Herstellung von Kohlenstoff-Haftschichten

Ein poliertes Cu-Blech (Größe 100 x 70 mm, Dicke 1 mm) wurde in eine Kathodenzerstäubungsanlage eingebracht. Parallel zu dem Cu-Blech wurde in einem Abstand von 60 mm ein rundes handelsübliches Kohlenstofftarget (Durchmesser 200 mm), bestehend aus pyrolytischem Kohlenstoff eingesetzt. Die Vakuumkammer der Kathodenzerstäubungsanlage wurde auf ein Vakuum von 5 x 10⁻⁷ mbar evakuiert. Danach wurde Argon bis zu einem Druck von 1 x 10⁻ mbar eingelassen. Bei Raumtemperatur wurde das Cu-Blech durch Anlegen eines RF-Plasmas mit einer Leistung von 500 Watt zunächst einer 10 Minuten dauernden Sputterätzbehandlung unterzogen. Nach Abschluß der Sputterätzbehandlung wurde der Ar-Druck auf 5 x 10⁻³ mbar reduziert. Durch Anlegen 5 einer DC-Spannung (Leistung 1000 W) an das Kohlenstoff-Target wurde auf dem Cu-Blech eine Schicht der Dicke 0,5 µm abgeschieden.

### B. Herstellung, Synchrotronbestrahlung und Entwicklung von Polymer/Träger-Verbunden

Ein handelsübliches Polylactid-Granulat, z.B. ®Resomer der Fa. Boehringer, Ingelheim, mit einem mittleren Molekulargewicht von 300 000 wurde in einer Schichtdicke von 200 µm auf das unter A beschriebene Kupferblech mit einer Oberflächenrauhigkeit unter 0,2 µm gepreßt. Die dafür verwendete Kupferplatte ist, wie unter (A) beschrieben, mit Kohlenstoff in einer Schichtdicke von 0,5 µm beschichtet.

Nach Synchrotronbestrahlung durch eine spezielle Röntgenmaske mit Säulenstrukturen (von 45 µm bis 5 µm Durchmesser) und nach der Entwicklung mit einem adaptierten Entwickler (vgl. DE-A-41 41 352, Beispiele) wurden Mikrostrukturen aus Polylactid erhalten, in welchen alle Säulen mit einem Durchmesser von 45 µm, 18 µm und von 8 µm stehen. Von den Säulen mit einem Durchmesser von 5 µm stehen noch 25 %.

Entsprechende Ergebnisse konnten auch bei Verwendung von Polymethylmethacrylat als Polymer unter Verwendung des GG-Entwicklers (siehe DE 30 39 110 C2) erhalten werden.

Anschließend konnten die im LIGA-Verfahren üblichen Folgeschritte Galvanoformung und Abformung durchgeführt werden.

### Beispiel 2

Es wurde wie in Beispiel 1 unter A. beschrieben verfahren; jedoch wurde vor dem Auftrag des Kohlenstoffs eine 10 nm dicke Chromschicht auf das Kupferblech aufgetragen, wobei letztere durch Kathodenzerstäubung eines handelsüblichen Chromtargets (Durchmesser 200 mm) bei einer Leistung von 300 Watt und einem Argondruck von 1 x 10⁻ mbar hergestellt wurde.

Es wurde weiter wie unter Beispiel 1 B. beschrieben verfahren. Dabei wurden vergleichbare Ergebnisse erhalten.

### Vergleichsbeispiel

Ein handelsübliches Polylactid-Granulat mit einem mittleren Molekulargewicht von 300 000 wurde in einer Schichtdicke von 200 µm auf ein 1 mm dickes Kupferblech mit einer Oberflächenrauhigkeit unter 0,2 µm gepreßt. Die dafür verwendete Kupferplatte war mit ca. 3,5 µm Titan beschichtet, welches anschließend oberflächlich mit Wasserstoffperoxid oxidiert wurde.

Nach Synchrotronbestrahlung durch eine spezielle Röntgenmaske mit Säulenstrukturen (von 45 µm bis 3 µm Durchmesser) und nach der Entwicklung mit einem adaptierten Entwickler (vgl. DE-A 41 41 352, Beispiele) wurden Mikrostrukturen aus Polylactid erhalten, wobei von Säulen mit einem Durchmesser von 45 µm nur noch 40 % auf dem Träger stehen, bei den restlichen Haftversagen aufgetreten ist, von Säulen mit einem Durchmesser von 18 µm nur noch 5 % stehen und kleinere Säulen nicht mehr vorhanden sind.

## Patentansprüche

1. Verfahren zur Herstellung von Mikrostrukturkörpern mit Strukturtiefen von mehreren µm bis in den mm-Bereich durch bildmäßiges Bestrahlen von Polymeren, die auf dimensionsstabilen Trägern mittels einer oder mehrerer Haftschichten aufgebracht sind, mit Synchrotronstrahlung und Entfernen der bildmäßig bestrahlten Bereiche, dadurch gekennzeichnet, daß die oberste, das Polymer berührende Haftschicht aus reinem Kohlenstoff oder Kohlenwasserstoffen mit unterstöchiometrischem Gehalt an Wasserstoff besteht, wobei diese Haftschicht durch Aufdampfen, Kathodenzerstäubung oder plasmaunterstützte chemische Gasphasenabscheidung auf den dimensionsstabilen Träger aufgebracht wird.

2. Verfahren nach Anspruch 1, dadurch gekennzeichnet, daß die Schichtdicke der obersten Haftschicht 10⁻³ µm bis 10 µm beträgt.

3. Verfahren nach einem der vorhergehenden Ansprüche, dadurch gekennzeichnet, daß der dimensionsstabile Träger elektrisch leitfähig ist.

4. Verfahren nach Anspruch 1 oder 2, dadurch gekennzeichnet, daß der dimensionsstabile Träger Halbleitereigenschaften aufweist.

5. Verfahren nach Anspruch 1 oder 2, dadurch gekennzeichnet, daß der dimensionsstabile Träger ein Isolator ist.

6. Verfahren nach Anspruch 4, dadurch gekennzeichnet, daß als dimensionsstabiler Träger ein Siliciumwafer verwendet wird.

7. Verfahren nach einem der vorhergehenden Ansprüche, dadurch gekennzeichnet, daß aus einem röntgenlichtempfindlichen Polymeren Mikrostrukturkörper mit Strukturtiefen zwischen 3 µm und 2000 µm und lateralen Abmessungen von unter 10 µm hergestellt werden.

8. Verfahren nach einem der vorhergehenden Ansprüche, dadurch gekennzeichnet, daß anschließend die für das LIGA-Verfahren üblichen Galvanikprozeßschritte und Abformprozeßschritte durchgeführt und Mikrostrukturkörper aus Metallen oder Kunststoffen hergestellt werden.

## Claims

1. A process for the production of microstructure elements having structure depths of from several µm into the mm range by imagewise irradiation of polymers applied to dimensionally stable substrates by means of one or more adhesion layers, with synchrotron radiation and removal of the areas which have been irradiated imagewise, wherein the uppermost adhesion layer in contact with the polymer comprises pure carbon or hydrocarbons having a substoichiometric content of hydrogen, this adhesion layer being applied to the dimensionally stable substrate by vapor deposition, cathode sputtering or plasma-supported chemical gas-phase deposition.

2. A process as claimed in claim 1, wherein the thickness of the uppermost adhesion layer is from 10⁻³ to 10 µm.

3. A process as claimed in either of the preceding claims, wherein the dimensionally stable substrate is electroconductive.

4. A process as claimed in claim 1 or 2, wherein the dimensionally stable substrate has semiconductor properties.

5. A process as claimed in claim 1 or 2, wherein the dimensionally stable substrate is an insulator.

6. A process as claimed in claim 4, wherein the dimensionally stable substrate is a silicon wafer.

7. A process as claimed in any one of the preceding claims, wherein microstructure elements having structure depths of from 3 to 2000 µm and lateral dimensions of less than 10 µm are produced from an X-ray sensitive polymer.

8. A process as claimed in any one of the preceding claims, wherein the electroforming and casting steps conventional in the LIGA process are subsequently carried out, and microstructure elements are produced from metals or plastics.

## Revendications

1. Procédé de préparation de corps à microstructures, avec des profondeurs de structures faisant plusieurs µm, jusque dans la plage des mm, par irradiation en mode image de polymères, appliqués sur des supports à dimensions stables, au moyen d'une ou plusieurs couches adhésives, avec un rayonnement synchrotron, et enlèvement des zones irradiées en mode image, caractérisé par le fait que la couche d'adhésion la plus haute, placée au contact du polymère, est constituée de carbone pur ou d'hydrocarbures ayant une teneur sous-stoechiométrique d'hydrogène, cette couche d'adhésion étant appliquée sur le support à dimensions stables par dépôt en phase vapeur, pulvérisation cathodique ou séparation des phases gazeuses par voie chimique assistée par plasma.

2. Procédé selon la revendication 1, caractérisé par le fait que l'épaisseur de couche de la couche d'adhésion la plus haute est de 10⁻³ à 10 µm.

3. Procédé selon l'une des revendications précédentes, caractérisé par le fait que le support à dimensions stables est conducteur de l'électricité.

4. Procédé selon la revendication 1 ou 2, caractérisé par le fait que le support à dimensions stables présente des propriétés semiconductrices.

5. Procédé selon la revendication 1 ou 2, caractérisé par le fait que le support à dimensions stables est un isolant.

6. Procédé selon la revendication 4, caractérisé par le fait que l'on utilise comme support à dimensions stables une plaquette en silicium.

7. Procédé selon l'une des revendications précédentes, caractérisé par le fait que, à partir de polymères sensibles aux rayons X, on fabrique des corps à microstructures ayant des profondeurs de structures comprises entre 3 µm et 2000 µm et ayant des dimensions latérales inférieures à 10 µm.

8. Procédé selon l'une des revendications précédentes, caractérisé par le fait qu'ensuite les étapes de procédé galvanique usuelles pour le procédé LIGA et les étapes de procédé de formation par enlèvement de matière sont effectuées et des corps à microstructures sont fabriqués à partir de métaux ou de matières plastiques.
